**Europäisches Patentamt**

**European Patent Office**

**Office européen des brevets**

(11) Veröffentlichungsnummer: **0 171 524**
A2

## (12) EUROPÄISCHE PATENTANMELDUNG

(21) Anmeldenummer: **85106558.1**

(22) Anmeldetag: **29.05.85**

(51) Int. Cl.⁴: **H 03 G 3/20**
H 03 G 7/00, H 03 G 3/00

(30) Priorität: **10.08.84 DE 3429508**

(43) Veröffentlichungstag der Anmeldung:
**19.02.86 Patentblatt 86/8**

(84) Benannte Vertragsstaaten:
**AT CH DE FR GB IT LI**

(71) Anmelder: **GRUNDIG E.M.V. Elektro-Mechanische Versuchsanstalt Max Grundig holländ. Stiftung & Co. KG.**
**Kurgartenstrasse 37**
**D-8510 Fürth(DE)**

(72) Erfinder: **Elsässer, Dieter**
**Tilsiter Strasse 23a**
**D-8500 Nürnberg(DE)**

(74) Vertreter: **Kolb, Max**
**Kurgartenstrasse 37**
**D-8510 Fuerth/Bayern(DE)**

(54) **Verfahren zur Pegel- und Lautstärkeeinstellung in einem NF-Verstärker und Anordnung zur Durchführung des Verfahrens.**

(57) Bei einem Verfahren zur Pegel- und Lautstärkeeinstellung in einem NF-Verstärker aus zwei Verstärkereinheiten wird der Pegel des zu verstärkenden Signals am Eingang der ersten Verstärkereinheit (1) kontinuierlich kontrolliert. Beim Eintreffen eines einen bestimmten Schwellwert überschreitenden Signalpegels wird ein diesem Pegel entsprechendes digitales Steuersignal erzeugt. Entsprechend dem Steuersignal wird der betreffende Signalpegel auf den vorgegebenen Schwellwert gedämpft. Der vom Ausgang der ersten Verstärkereinheit (1) zum Eingang der zweiten Verstärkereinheit (2) gelangende Signalpegel wird auf einen der gewünschten Lautstärke entsprechenden Wert eingestellt.

EP 0 171 524 A2

Croydon Printing Company Ltd.

## VERFAHREN ZUR PEGEL- UND LAUTSTÄRKEEINSTELLUNG IN EINEM NF-VERSTÄRKER UND ANORDNUNG ZUR DURCHFÜHRUNG DES VERFAHRENS

### BESCHREIBUNG

Die Erfindung betrifft ein Verfahren zur Pegel- und Lautstärkeeinstellung in einem NF-Verstärker aus zwei Verstärkereinheiten und eine Anordnung zur Durchführung des Verfahrens.

Bei der Mehrzahl der bekannten NF-Verstärkeranordnungen erfolgt die Pegel- und Lautstärkeeinstellung über ein einziges, am Eingang des Verstärkers liegendes Dämpfungsglied. Es sind auch Verstärkeranordnungen bekannt, die außerdem noch über zusätzliche, verschiedenenEingängen zugeordnete Dämpfungsglieder verfügen, mit deren Hilfe eine zu hohe Eingangsspannung heruntergeteilt wird, bevor sie auf den eigentlichen Lautstärkesteller gelangt. Durch die eingangsseitige Pegel- und Lautstärkeeinstellung wird erreicht, daß bei der durch die Norm vorgegebenen relativ hohen Eingangsempfindlichkeit der Verstärkeranordnung auch sehr hohe Eingangsspannungen verarbeitet werden können. Die Werte für die Eingangsempfindlichkeit und die maximale verzerrungsfrei zu verarbeitende Eingangsspannung liegen üblicherweise in der Größenordnung von 0,15 bzw. 10 Volt. Für Eingangsspannungen unter 0,15 Volt (z.B. Ausgangsspannungen von Mikrofonen oder Magnettonabnehmern) sind gesonderte Vorverstärker erforderlich.

Der Nachteil solcher NF-Verstärkeranordnungen mit der bekannten Art der Lautstärke- und Pegeleinstellung bzw. -voreinstellung liegt vor allem in dem relativ geringen Störabstand bei kleinen Lautstärken. Denn in diesem Betriebszustand wird das Eingangssignal durch den am Eingang liegenden Lautstärkesteller sehr stark gedämpft und demzufolge die gesamte nachfolgende Anordnung hoher Verstärkung ($v = v_1 \cdot v_2$) nur unzureichend ausgesteuert. Hierbei wird der bei Vollaussteuerung erreichbare Störabstand durch das Eigenrauschen der Verstärkeranordnung erheblich verringert. Bezogen auf eine Ausgangsleistung von 50 mW, liegt der Störabstand derartiger NF-Verstärker bei etwa 60 dB. Dieser Wert ist unbefriedigend, insbesondere im Hinblick auf den Störabstand eines CD-Spielers von etwa 80 dB. Auch bei der Verstärkung von Signalen, die einen großen Dynamikumfang aufweisen, macht sich der bei kleinen Lautstärken auftretende Störabstand negativ bemerkbar.

Der Erfindung liegt die Aufgabe zugrunde, ein Verfahren der im Oberbegriff des Anspruchs 1 angegebenen Art und eine Anordnung zur Durchführung des Verfahrens so auszubilden, daß das bei kleinen Lautstärken erreichbare Signal/Rauschverhältnis, das insbesondere auch bei der Verstärkung von Signalen mit großer Dynamik von Bedeutung ist, verbessert wird.

Diese Aufgabe wird gemäß der Erfindung durch die im Kennzeichen des Anspruchs 1 bzw. Anspruchs 5 angegebenen Maßnahmen gelöst. Vorteilhafte Weiterbildungen der Erfindung und bevorzugte Ausführungsbeispiele der Erfindung für eine Anordnung zur Durchführung des Verfahrens sind in den Unteransprüchen gekennzeichnet.

Bei dem Verfahren gemäß der Erfindung wird der Eingangssignalpegel des zu verstärkenden Signals nicht wie im bekannten Falle über ein veränderbares Dämpfungsglied statisch voreingestellt, sondern er wird, sobald er einen bestimmten Schwellwert erreicht bzw. überschreitet, in vorteilhafter Weise automatisch und kontinuierlich so geregelt, daß der Verstärker eingangsseitig gerade nicht übersteuert wird. An einer geeigneten Schnittstelle innerhalb der Verstärkeranordnung wird die individuell veränderbare Lautstärkeeinstellung vorgenommen.

Erfolgt die eingangsseitige kontinuierliche Regelung des Signalpegels mit einer genügend kleinen Zeitkonstanten, dann weist das am Ausgang des Verstärkers abnehmbare Signal zwar einen gewissen Dynamikverlust auf, der jedoch, falls er nicht sogar erwünscht ist, an der genannten Schnittstelle durch eine der Eingangssignalregelung entsprechend entgegengesetzt wirkende Regelung rückgängig gemacht werden kann.

Der Vorteil dieser Maßnahme besteht darin, daß das Signal/Rauschverhältnis zum einen weniger stark von der Dynamik des zu verstärkenden Signals abhängig ist und zum anderen bis zu der genannten Schnittstelle stets seinen optimalen Wert annimmt. Wird die Schnittstelle so gewählt, daß der Verstärkungsfaktor $v_1$ der davor liegenden Verstärkereinheit wenigstens in der gleichen Größenordnung liegt wie der Verstärkungsfaktor $v_2$ der danach liegenden Verstärkereinheit, dann wird dieses Signal/Rauschverhältnis auch nach der Schnittstelle bei entsprechender Dämpfung des verstärkten Signals nicht wesentlich verschlechtert. Denn im Gegensatz zum Bekannten ist der nach dem Dämpfungsglied eingehende, störende Eigenrauschanteil des Verstärkers vernachlässigbar klein.

Im folgenden ist ein Ausführungsbeispiel zur Durchführung des Verfahrens gemäß der Erfindung anhand einer Zeichnung näher erläutert.

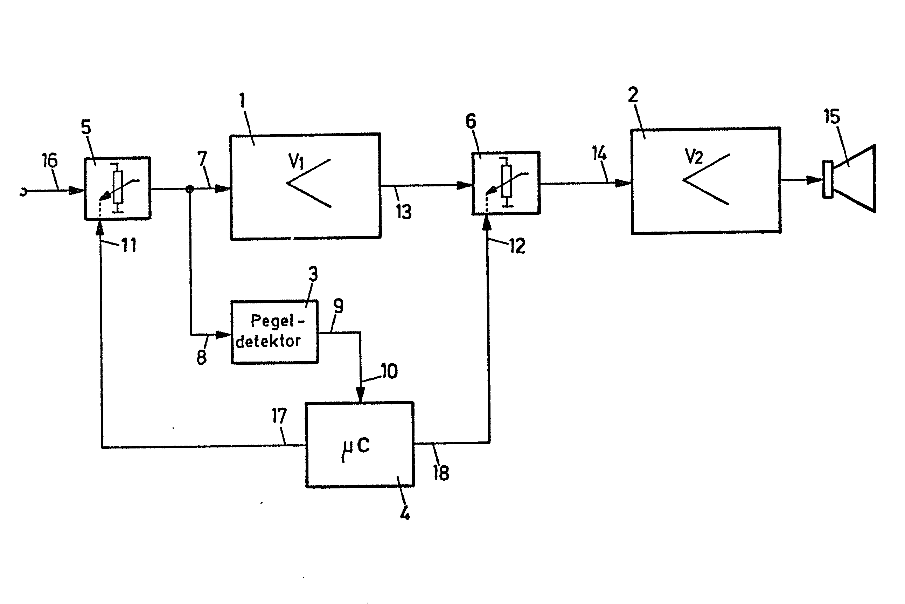

Die Figur zeigt ein vereinfachtes Blockschaltbild einer entsprechend der Erfindung geregelten NF-Verstärkeranordnung.

Hierbei ist ein erstes elektronisch steuerbares Dämpfungsglied 5 an den Eingang 7 einer ersten Verstärkereinheit 1 sowie an den Eingang 8 eines Signalpegeldetektors 3 angeschlossen. Während der Ausgang 9 des Signalpegeldetektors 3 mit dem Steuereingang 10 eines Mikrocomputers 4 in Verbindung steht, ist der eine Schnittstelle bildende Ausgang 13 der ersten Verstärkereinheit 1 über ein zweites elektronisch steuerbares Dämpfungsglied 6 an den Eingang 14 einer zweiten Verstärkereinheit 2 geschaltet. Deren Ausgang ist mit einem elektroakustischen Wandler 15 verbunden. Ferner sind die Regeleingänge 11 und 12 der beiden elektronisch steuerbaren Dämpfungsglieder 5 bzw. 6 an die Steuerausgänge 17 bzw. 18 des Mikrocomputers 4 angeschlossen.

Bei einer derartigen Anordnung gelangt das zu verstärkende Signal über den Eingang 16 an das elektronisch steuerbare Dämpfungsglied 5. Beim Anlegen der Signalspannung stellt der Mikrocomputer 4 dieses Dämpfungsglied zunächst auf den Dämpfungsfaktor Null ein. Anschließend mißt bzw. kontrolliert der Pegeldetektor 3 kontinuierlich den am Ausgang des Dämpfungsgliedes 5 anstehenden und auf den Eingang der ersten Verstärkereinheit 1 geführten Signalpegel. Solange dieser Pegel einen vorgegebenen Schwellwert nicht überschreitet, wird der zu Beginn über den Mikrocomputer eingestellte Dämpfungsfaktor Null nicht verändert. Übersteigt jedoch zu irgendeinem Zeitpunkt der Signalpegel am Eingang 8 des Pegeldetektors den vorgegebenen Schwellwert, dann gibt der Pegeldetektor ein diesem Pegel entsprechendes digitales Steuersignal an den Mikrocomputer ab. Dieser erhöht demzufolge über den Regeleingang 11 des Dämpfungsgliedes 5 dessen Dämpfungsfaktor so lange, bis der Signalpegel am Eingang des Pegeldetektors und damit am Eingang der ersten Verstärkereinheit 1 auf den vorgegebenen Schwellwert abgesunken ist. Auf diese Weise wird jeder Pegeländerung mit einer entsprechenden Änderung des Dämpfungsfaktors begegnet. Der Schwellwert, bei dem die Regelung einsetzt und auf den die Eingangsspannung gedämpft wird, entspricht dem Spannungswert, bei dem die erste Verstärkereinheit gerade nicht übersteuert wird.

Durch die kontinuierliche Regelung des Eingangssignalpegels oberhalb eines bestimmten Schwellwertes wird der ursprüngliche Dynamikumfang des zu verstärkenden Signals begrenzt (kleine Regelzeitkonstante). Falls eine derartige Dynamikkompression beibehalten werden soll, dient das zweite über den Mikrocomputer steuerbare Dämpfungsglied 6 ausschließlich zur individuellen Einstellung der gewünschten Lautstärke. In diesem Zusammenhang ist zu erwähnen, daß eine Begrenzung des Dynamikumfangs erwünscht sein kann, um durch die damit verbundene Linearisierung des Signalamplitudenganges die Verständlichkeit eines zu verstärkenden und elektroakustisch zu wandelnden Signals zu erhöhen.

Für den Fall, daß der volle Dynamikumfang des ursprünglichen Signals erhalten bleiben bzw. wieder hergestellt werden soll, wird das zweite Dämpfungsglied 6 über den Mikrocomputer bei einem fest eingestellten Dämpfungsfaktor, der die Grundlautstärke bestimmt, simultan mit dem ersten Dämpfungsglied 5 so gesteuert, daß von ihm jede durch das erste Dämpfungsglied ausgeführte Dämpfungsänderung ausgeglichen wird. Am Eingang 14 der zweiten Verstärkereinheit ist somit wieder ein Signal mit der ursprünglichen Dynamik vorhanden.

VERFAHREN ZUR PEGEL- UND LAUTSTÄRKEEINSTELLUNG IN EINEM NF-VERSTÄRKER UND ANORDNUNG ZUR DURCHFÜHRUNG DES VERFAHRENS

PATENTANSPRÜCHE

1. Verfahren zur Pegel- und Lautstärkeeinstellung in einem NF-Verstärker aus zwei Verstärkereinheiten, dadurch gekennzeichnet, daß der Pegel des zu verstärkenden Signals am Eingang der ersten Verstärkereinheit (1) kontinuierlich kontrolliert wird, daß beim Eintreffen eines einen bestimmten Schwellwert überschreitenden Signalpegels ein diesem Pegel entsprechendes digitales Steuersignal erzeugt wird, daß entsprechend dem Steuersignal der betreffende Signalpegel auf den vorgegebenen Schwellwert gedämpft wird, und daß der vom Ausgang der ersten Verstärkereinheit (1) zum Eingang der zweiten Verstärkereinheit (2) gelangende Signalpegel auf einen der gewünschten Lautstärke entsprechenden Wert eingestellt wird.

2. Verfahren nach Anspruch 1, dadurch gekennzeichnet, daß die Eingangspegel der beiden Verstärkereinheiten (1, 2) simultan so gesteuert werden, daß jede Dämpfungsänderung am Eingang der ersten Verstärkereinheit (1) durch eine entgegengesetzt wirkende Dämpfungsänderung am Eingang der zweiten Verstärkereinheit (2) ausgeglichen wird.

3. Verfahren nach Anspruch 1 oder 2, dadurch gekennzeichnet, daß der Schwellwert für den zu regelnden Signalpegel am Eingang des Verstärkers (1, 2) so gewählt wird, daß die erste Verstärkereinheit gerade nicht übersteuert wird.

4. Verfahren nach einem oder mehreren der Ansprüche 1 bis 3, dadurch gekennzeichnet, daß zur Steuerung des Eingangssignalpegels der ersten Verstärkereinheit (1) oder zur Steuerung der Eingangssignalpegel der beiden Verstärkereinheiten (1, 2) eine im Verhältnis zu den zeitlichen Signalpegeländerungen kleine Regelzeitkonstante gewählt wird.

5. Anordnung zur Durchführung des Verfahrens nach einem oder mehreren der Ansprüche 1 bis 4, dadurch gekennzeichnet, daß der Eingang (7) des durch eine Schnittstelle in zwei Verstärkereinheiten (1, 2) unterteilten Verstärkers mit dem Eingang (8) eines Signalpegeldetektors (3) verbunden ist, dessen Ausgang (9) an den Steuereingang (10) eines Mikrocomputers (4) gelegt ist, und daß der Mikrocomputer mit den Regeleingängen (11, 12) zweier elektronisch steuerbarer Dämpfungsglieder (5, 6) verbunden ist, von denen das erste an den Eingang (7) der ersten Verstärkereinheit (1) angeschlossen und das zweite zwischen die Schnittstelle der ersten und zweiten Verstärkereinheit geschaltet ist.

6.   Anordnung nach Anspruch 5, dadurch gekennzeichnet, daß die Schnittstelle den Verstärker so unterteilt, daß die Verstärkungsfaktoren $v_1$ und $v_2$ der beiden Verstärkereinheiten (1, 2) in der gleichen Größenordnung liegen.

7.   Anordnung nach Anspruch 5, dadurch gekennzeichnet, daß die Schnittstelle den Verstärker so unterteilt, daß die erste Verstärkereinheit (1) einen größeren Verstärkungsfaktor aufweist als die zweite.

8.   Anordnung nach einem oder mehreren der Ansprüche 5 bis 7, dadurch gekennzeichnet, daß die beiden elektronisch steuerbaren Dämpfungsglieder (5, 6) als Spannungsteiler mit veränderbarem Teilungsverhältnis ausgebildet sind.

Beschreibung:

../4

Reg. 1956

1/1

0171524